# EUROPEAN PATENT SPECIFICATION

(11) **EP 2 839 517 B1**
(45) Date of publication and mention of the grant of the patent: **06.01.2016**
(21) Application number: 13725796.0
(22) Date of filing: 16.04.2013
(51) Int. Cl.: H01L 31/054

(54) **A HIGH-CONCENTRATION PHOTOVOLTAIC PANEL**
HOCHKONZENTRIERTE PHOTOVOLTAIKTAFEL
PANNEAU PHOTOVOLTAÏQUE À HAUTE CONCENTRATION

(30) Priority: 17.04.2012 IT BO20120207
(43) Date of publication of application: 25.02.2015
(73) Proprietor: Gpiii S.r.l., 40014 Crevalcore (Bologna) (IT)
(72) Inventor: PASSERINI, Gianluca, I-40014 Crevalcore (Bologna) (IT)
(74) Representative: Dall'Olio, Christian
(86) International application number: PCT/IB2013/053012
(87) International publication number: WO 2013/156929

(56) References cited:
- US-A- 4 086 485
- US-A1- 2010 139 768

## Description

### FIELD OF INVENTION

The present invention relates to the technical sector of concentration photovoltaic panels.

### DESCRIPTION OF PRIOR ART

Concentration photovoltaic panels are subdivided into types having high (HCPV) and low (LCPV) concentration substantially as a function of the ratio between the surfaces of captured solar rays and the surface of the photovoltaic cell, which is commonly known as the number of suns.

The present invention relates in detail to high concentration panels.

US 4 086 485 discloses a concentration panel.

In the prior art, a high-concentration photovoltaic panel, able to convert solar energy into electrical energy, comprises a box element provided superiorly with a closing plate made of a transparent material (for example glass or plastic), for enabling the solar rays to penetrate internally of the box element.

A plurality of modules are flanked internally of the box element, each of which comprises, for example:
- a photovoltaic cell for converting solar energy into electrical energy;
- an optical system comprising a first reflective surface (also known as a primary optic) and a second reflective surface (also known as a secondary optic), positioned at a predetermined distance;
- a support base on which the photovoltaic cell and an electric circuit connected to the photovoltaic cell are fixed.

In detail, the primary optic exhibits a concave profile (generally parabolic) and comprises a through-hole in which the support base is positioned, while the secondary optic exhibits a convex profile (generally hyperbolic) and is fastened to the transparent closing plate of the box element, arranged such as to face the through-hole of the primary optic.

The support base is arranged such that the photovoltaic cell is facing the second optic.

In particular the primary optic and the secondary optic are profiled and reciprocally distanced such that a beam of solar rays that penetrates the box element through the transparent closing plate is reflected by the primary optic towards the secondary optic, and from the secondary optic towards the photovoltaic cell.

The described optic configuration is commonly known as a *"Cassegrain configuration".*

The support base is further provided with fins for dissipating the heat, so as to prevent overheating of the photovoltaic cell.

To enable conversion of the solar energy into electrical energy, the panel is associated to a tracking system able to automatically enable, instant-by-instant, the optimal orientation of the optical concentration system with respect to the sun.

Solar tracking technology has the aim of positioning the panel, and thus each module, in such a way that the solar rays are concentrated by the primary and secondary optics onto the photovoltaic cells of each module contained in the box element.

As solar tracking technology is intrinsically subject to small movement errors, correct positioning of each module is not always guaranteed and consequently there can be a deviated portion of solar rays that when reflected by the secondary optic is not conveyed towards the photovoltaic cell.

In order to obviate this drawback each module further comprises a device, commonly known as a homogenizer, for conveying the above-mentioned deviated portion of solar rays towards the photovoltaic cell.

In the above-described configuration, the homogeniser comprises a profiled body with a trunco-pyramidal geometry, generally made of high-transparency glass, the smaller base of which is arranged facing and in proximity of the photovoltaic cell and exhibits the same geometry as the photovoltaic cell.

The larger base of the homogeniser is therefore facing towards the secondary optic in order to collect and convey the deviated solar rays that in the absence of the homogenizer would not strike the photovoltaic cell.

Generally the homogeniser is fixed on the photovoltaic cell by high-transparency glue and with the aid of external handling organs which enable centring and fixing thereof during the steps of movement and assembly.

To guarantee optimal concentration of the solar rays on the photovoltaic cell of each module housed internally of the box element, for each module it is necessary to very precisely position the primary and secondary optics, the photovoltaic cell and the support base on which the photovoltaic cell is fastened with respect to one another.

If the homogeniser is included, as in the majority of cases it is necessary to very precisely position this too with respect to the photovoltaic cell.

As mentioned above, the positioning and the centring of the homogeniser with respect to the photovoltaic cell is carried out using external handling organs which though very precise are extremely expensive.

They enable positioning the homogeniser on the photovoltaic cell and the fixing thereof by high-transparency glue.

Generally, the support base is fastened on the structure of the primary optic, with concave geometry, using screw fastening means, and the associated group comprising the photovoltaic cell and the homogenizer, glued thereto.

The support base is housed in the through-hole of the primary optic.

Any positioning errors in the positioning of the support base on the primary optic lead to a positioning error of the photovoltaic cell with respect to the primary optic.

Generally the secondary optic, having a convex geometry, is fastened to the transparent closing plate of the box element of the panel.

Any positioning errors of the transparent plate during the step of closing on the box element lead to an error in positioning of the secondary optic with respect both to the primary optic and to the photovoltaic cell.

The above positioning errors can prejudice the correct conveying of the solar rays from the primary and secondary optics towards the photovoltaic cells of each module.

### SUMMARY OF THE INVENTION

The aim of the present invention is to provide a high-concentration photovoltaic panel, able to attain optimal conveying of the solar rays onto the photovoltaic cell of each module housed internally of the box element of the photovoltaic panel, enabling a particularly precise positioning and centring of the primary and secondary optics with respect to the photovoltaic cells and the support bases on which the photovoltaic cells are fixed.

A further aim of the present invention is to provide a high-concentration photovoltaic panel which can enable centring and fixing steps of the single constituent elements that are particularly rapid and precise.

The above aims are attained with a high-concentration photovoltaic panel, comprising a box element exhibiting a bottom, a pair of longitudinal lateral walls which rise from the bottom, and a pair of heads; a plate made of a transparent material for closing the box element, allowing solar rays to penetrate internally of the box element; a plurality of photovoltaic modules housed internally of the box element for production of electrical energy sourcing from solar energy; each photovoltaic module comprising:
a photovoltaic cell for converting solar energy into electrical energy;
an optical system positioned internally of the box element, which receives the solar rays that penetrate through the transparent plate and conveys the rays in a direction of the photovoltaic cell;
a support base on which the photovoltaic cell and an electric circuit connected to the photovoltaic cell are fixed;
the photovoltaic panel being characterised in that it comprises: first means enabling at least a centring of the support base of the photovoltaic module with respect to the bottom of the box element; means for enabling centring of the optical system of the photovoltaic module with respect to the box element.

In special embodiments of the invention, the high-concentration photovoltaic panel of the invention comprises one or more of the following characteristics, considered singly or in combination:
the optical system comprises a first reflective group having a concave geometry, positioned internally of the box element, which first reflective group receives the solar rays that penetrate through the transparent plate; and a second reflective group having a convex geometry, associated to the closing plate, which receives the solar rays arriving from the first reflective group and conveys them in a direction of the photovoltaic cell; and in that it comprises second means for enabling at least a centring of the first reflective group with respect to the box element, and third means for enabling at least a centring of the second reflective group, associated to the closing plate, with respect to the lateral walls of the box element;
the first means comprise a plurality of first pins provided on the support base, suitable for inserting in corresponding first through-holes afforded in the bottom of the box element;
the second means comprise a plurality of second pins provided by the first reflective group, destined to insert in corresponding second through-holes afforded in the box element;
the first pins or the second pins have a conical or truncoconical geometric profile, such as to facilitate insertion into the corresponding first or second through-holes;
the first pins insert in the corresponding first through-holes by interference, such as to enable fixing the support base to the bottom of the box element;
the second pins insert freely in the corresponding second through-holes, the second pins, after insertion thereof in the second through-holes, being deformed such as to enable fixing the first reflective group to the box element;
the second through-holes are afforded at the bottom of the box element;
the third means comprise a longitudinal seating which emerges from an upper edge of each lateral wall of the box element, at least able to restingly receive and laterally contain the closing plane to which the second reflective group is associated;
each longitudinal seating exhibits an L-profile and comprises a first portion, suitable for restingly receiving the closing plate, and a second portion able to laterally abut the closing plate;
each longitudinal seating further comprises a third portion, facing the first portion, able to retain the closing plate;
it comprises application of gluing means on at least the first portion, preferably also on the second portion, preliminarily to positioning the closing plate, such as to enable fixing the closing plate to the lateral walls of the box element.

### BRIEF DESCRIPTION OF THE DRAWINGS

The characteristics of the invention will be explained in the following in which some preferred but not exclusive embodiments are described by way of non-exclusive example, with reference to the accompanying tables of drawings in which:
- figure 1 illustrates a perspective view in vertical section of the photovoltaic panel of the invention, with three particularly significant details shown in larger scale;

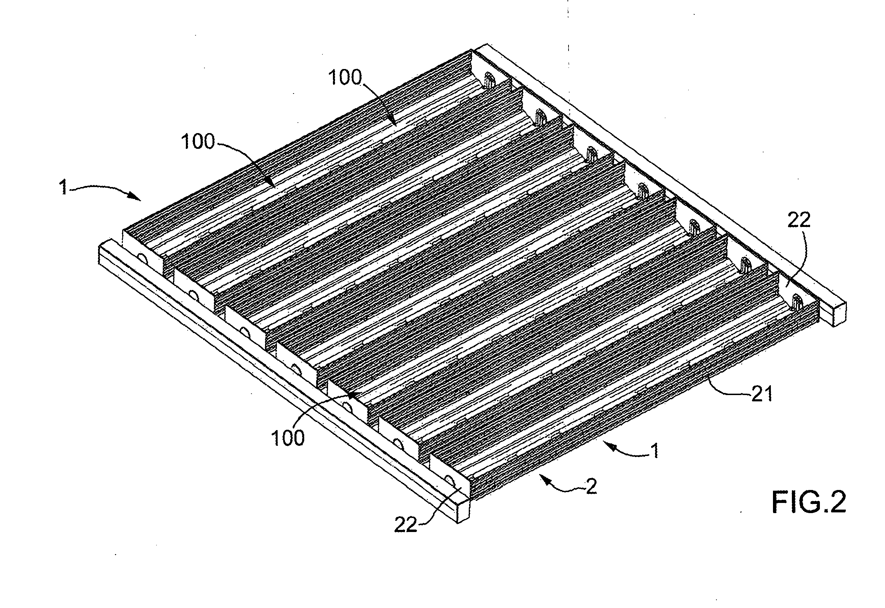

- figure 2 is a perspective view of a group of photovoltaic panels according to the invention.

### DESCRIPTION OF PREFERRED EMBODIMENTS

With reference to the tables of drawings, general reference numeral 1 denotes the high-concentration photovoltaic panel of the invention which, in known ways, comprises a box element 2 which identifies a bottom 20, a pair of longitudinal lateral walls 21 which rise from the bottom 20, and a pair of heads 22; a plate 3 made of a transparent material for closing the box element 2, allowing solar rays to penetrate internally of the box element 2; a plurality of photovoltaic modules 100 housed internally of the box element 2 for production of electrical energy sourcing from solar energy.

Each photovoltaic module 100 comprises, in known ways;
a photovoltaic cell 4 for converting solar energy into electrical energy;
an optical system 5, 6 positioned internally of the box element 2, which receives the solar rays that penetrate through the transparent plate 3 and conveys the rays in a direction of the photovoltaic cell 4;
a support base 7 on which the photovoltaic cell 4 and an electric circuit connected to the photovoltaic cell 4 are fixed.

By way of example, in the figures reference is made to what is known as the *"Cassegrain configuration"* in which the optical system 5, 6 comprises a concave first reflective group (for example parabolic), positioned internally of the box element 2, which receives the solar rays that penetrate through the transparent plate 3; and a second reflective group 6 having a convex geometry (for example hyperbolic), associated to the closing plate 3, which receives the solar rays in arrival from the first reflective group 5 and conveys them in the direction of the photovoltaic cell 4.

The support base 7 is advantageously positioned in proximity of a first through-seating realised in the first reflective group 5, and at a second through-seating realised in the bottom 20 of the box element 2.

By way of non-limiting example, the photovoltaic panel 1 includes the bottom 20 and the lateral longitudinal walls 21 of the box element 2 realised in a single body.

The photovoltaic panel 1 innovatively comprises first means 8 which enable at least the centring of the support base 7 of each photovoltaic module 100 with respect to the bottom 20 of the box element 2; as well as means 9, 10 which enable centring the optical system 5, 6 of the photovoltaic module 100 with respect to the box element 2.

In particular second means 9 are provided, which enable at least a centring of the first reflective group 5 with respect to the box element 2, and third means 10 that can enable at least centring of the second reflective group 6, associated to the closing plate 3 with respect to the lateral walls 21 of the box element 2.

In accordance with the longitudinal dimensions of the closing plate 3, the second reflective group 6 can be fixed to or realised in a single body with the closing plate 3.

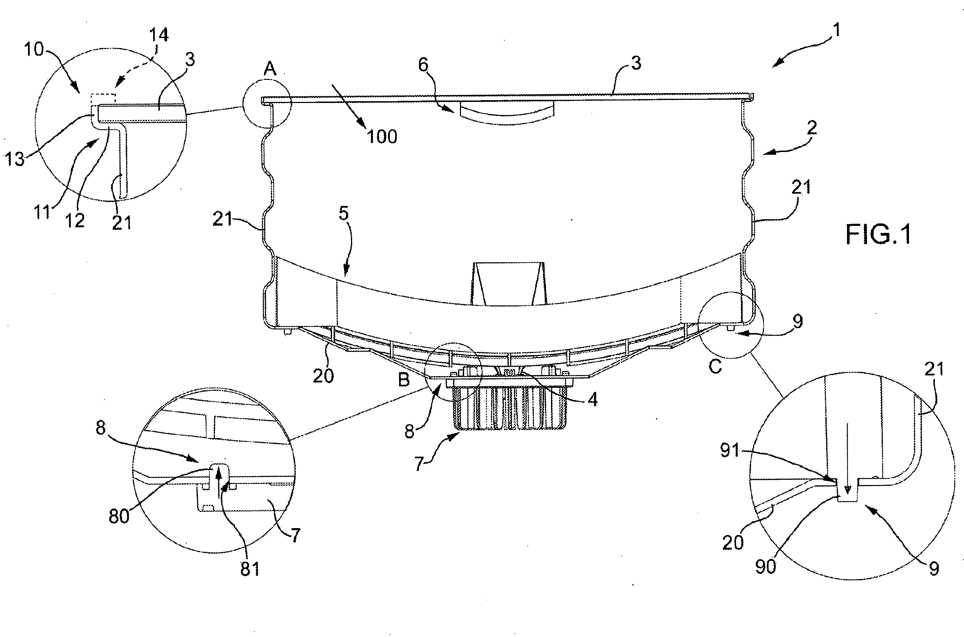

With reference to the detail A denoted in figure 1, the third means 10 comprise a longitudinal seating 11 which emerges from the upper edge of each lateral wall 21 of the box element 2, able to restingly receive and laterally contain the closing plate 3 to which the second reflective group 6 is associated.

In particular each longitudinal seating 11 is at least L-shaped and comprises a first portion 12 able to resting receive the closing plate 3, and a second portion able to laterally abut the closing plate 3.

Note that before positioning the closing plate 3 glue is applied on at least the first portion 12, preferably also on the second portion 13 of the longitudinal seatings 11 which enables fixing the closing plate 3 to the lateral walls 21 of the box element 2.

In accordance with the material with which the box element 2 is realised, in a variant the longitudinal seating 11 might be U-shaped, including a further third portion 14 (in a broken line in detail A) facing the third portion 12 and able to retain the closing plate 3.

In this case the U-shaped longitudinal seatings 11 might advantageously contain sealing means, for example seal gaskets.

With reference to detail B of figure 1, the first means 8 comprise a plurality of first pins 80 provided on the support base 7, able to insert in corresponding first through-holes 81 made in proximity of the peripheral edges of the second through-seating made in the bottom 20 of the box element 2.

The first pins 80 are advantageously profiled in a conical or truncoconical geometry to facilitate the insertion of the corresponding first through-holes 81.

In particular, the first pins 80 insert in the corresponding first through-holes 81 by friction, such as to enable fastening the support base 7 to the bottom 20 of the box element 2.

This makes the fixing of the support base 7 brought nearingly to the bottom 20 from below particularly precise and simple.

With reference to detail C included in figure 1, the second means 9 comprise a plurality of second pins 90 provided on the first reflective group 5, able to insert in corresponding second through-holes 91 afforded in the box element 2, preferably at the bottom 20 of the box element 2.

The second pins 90 are advantageously conically or truncoconically profiled, so as to facilitate insertion thereof in the corresponding second through-holes 91.

The second pins 90 also freely insert in the corresponding second through-holes 91, which second pins 90, following insertion thereof in the second through-holes 91, are deformed such as to enable fastening of the first reflective group 5 to the box element 2.

In detail, the second pins 90 can be hot-riveted in the second through-holes 91 afforded in the box element 2.

This makes the positioning and subsequent fixing of the first reflective group 5 brought nearingly to the bottom 20 from above particularly precise and easy.

From the above it clearly emerges how the photovoltaic panel of the invention can enable the optimal conveying of the solar rays onto the photovoltaic cell of each module housed internally of the box element of the photovoltaic panel, enabling an especially precise positioning and centring of the primary and secondary optics with respect to the photovoltaic cells and the support bases on which the photovoltaic cells are fixed.

In fact, differently to the prior art the positioning and centring are carried out with respect to a single reference system constituted by the box element.

The first means enable centring (and subsequently fixing) the support base to the bottom of the box element, while the second means enabling centring (and subsequent fixing) of the first reflective group to the box element, and the third means enable centring (and subsequently fixing) the closing plate with respect to the lateral walls of the box element.

The centring of the closing plate with respect to the lateral walls of the box element consequently also involves the centring of the associated second reflective group with respect to the lateral walls of the box element.

It is clear how the proposed photovoltaic panel enables, for the single constituent elements, steps of centring and fixing that are particularly rapid and precise.

## Claims

1. A high-concentration photovoltaic panel, comprising a box element (2) exhibiting a bottom (20), a pair of longitudinal lateral walls (21) which rise from the bottom (20), and a pair of heads (22); a plate (3) made of a transparent material for closing the box element (2), allowing solar rays to penetrate internally of the box element (2); a plurality of photovoltaic modules (100) housed internally of the box element (2) for production of electrical energy sourcing from solar energy; each photovoltaic module (100) comprising:
a photovoltaic cell (4) for converting solar energy into electrical energy;
an optical system (5, 6) positioned internally of the box element (2), which receives the solar rays that penetrate through the transparent plate (3) and conveys the rays in a direction of the photovoltaic cell (4);
a support base (7) on which the photovoltaic cell (4) and an electric circuit connected to the photovoltaic cell (4) are fixed;
the photovoltaic panel (1) being **characterised in that** it comprises: first means (8) enabling at least a centring of the support base (7) of the photovoltaic module (100) with respect to the bottom (20) of the box element (2); means (9, 10) for enabling centring of the optical system (5, 6) of the photovoltaic module (100) with respect to the box element (2).

2. The panel of claim 1, **characterised in that** the optical system (5, 6) comprises a first reflective group (5) having a concave geometry, positioned internally of the box element (2), which first reflective group (5) receives the solar rays that penetrate through the transparent plate (3); and a second reflective group (6) having a convex geometry, associated to the closing plate (3), which receives the solar rays arriving from the first reflective group (5) and conveys them in a direction of the photovoltaic cell (4); and **in that** it comprises second means (9) for enabling at least a centring of the first reflective group (5) with respect to the box element (2), and third means (10) for enabling at least a centring of the second reflective group (6), associated to the closing plate (3), with respect to the lateral walls (21) of the box element (2).

3. The panel of claim 1 or 2, **characterised in that** the first means (8) comprise a plurality of first pins (80) provided on the support base (7), suitable for inserting in corresponding first through-holes (81) afforded in the bottom (20) of the box element (2).

4. The panel of claim 2 or 3, **characterised in that** the second means (9) comprise a plurality of second pins (90) provided by the first reflective group (5), destined to insert in corresponding second through-holes (91) afforded in the box element (2).

5. The panel of claim 3 or 4, **characterised in that** the first pins (80) or the second pins (90) have a conical or truncoconical geometric profile, such as to facilitate insertion into the corresponding first or second through-holes (81, 91).

6. The panel of claim 3 or 5, **characterised in that** the first pins (80) insert in the corresponding first through-holes (81) by interference, such as to enable fixing the support base (7) to the bottom (20) of the box element (2).

7. The panel of claim 4 or 5, **characterised in that** the second pins (90) insert freely in the corresponding second through-holes (91), the second pins (90), after insertion thereof in the second through-holes (91), being deformed such as to enable fixing the first reflective group (5) to the box element (2).

8. The panel of claims 4, 5 or 7, **characterised in that** the second through-holes (91) are afforded at the bottom (20) of the box element (2).

9. The panel of one of claims from 2 to 8, **characterised in that** the third means (10) comprise a longitudinal seating (11) which emerges from an upper edge of each lateral wall (21) of the box element (2), at least able to restingly receive and laterally contain the closing plane (3) to which the second reflective group (6) is associated.

10. The panel of claim 9, **characterised in that** each longitudinal seating (11) exhibits an L-profile and comprises a first portion (12), suitable for restingly receiving the closing plate (3), and a second portion (13) able to laterally abut the closing plate (3).

11. The panel of claim 10, **characterised in that** each longitudinal seating (11) further comprises a third portion (14), facing the first portion (12), able to retain the closing plate (3).

12. The panel of claim 10 or 11, **characterised in that** it comprises application of gluing means on at least the first portion (12), preferably also on the second portion (13), preliminarily to positioning the closing plate (3), such as to enable fixing the closing plate (3) to the lateral walls (21) of the box element (2).

## Patentansprüche

1. Hochkonzentrierendes Photovoltaikmodul, beinhaltend: ein kastenförmiges Element (2), das einen Boden (20), ein Paar länglicher Seitenwände (21), die sich vom Boden (20) aus nach oben erstrecken, und ein Paar Kopfteile (22) aufweist; eine Platte (3) aus einem transparenten Werkstoff zum Verschluss des kastenförmigen Elements (2), durch die Sonnenstrahlen in das Innere des kastenförmigen Elements (2) eintreten können; mehrere Photovoltaikmodule (100), die im Innern des kastenförmigen Elements (2) untergebracht sind und zur Erzeugung elektrischer Energie aus Solarenergie dienen; wobei jedes Photovoltaikmodul (100) Folgendes beinhaltet:
eine photovoltaische Zelle (4) zur Umwandlung von Solarenergie in elektrische Energie;
ein optisches System (5, 6), das im Innern des kastenförmigen Elements (2) angeordnet ist und dazu dient, die über die transparente Platte (3) eintretenden Sonnenstrahlen aufzunehmen und die Strahlen in Richtung der photovoltaischen Zelle (4) zu lenken;
eine Trägerbasis (7), auf der die photovoltaische Zelle (4) und ein mit der photovoltaischen Zelle (4) verbundener elektrischer Schaltkreis befestigt sind;
wobei das Photovoltaikmodul (1) **dadurch gekennzeichnet ist, dass** es Folgendes beinhaltet: erste Mittel (8), die zumindest ein Zentrieren der Trägerbasis (7) des Photovoltaikmoduls (100) relativ zu dem Boden (20) des kastenförmigen Elements (2) ermöglichen; Mittel (9, 10), die das Zentrieren des optischen Systems (5, 6) des Photovoltaikmoduls (100) relativ zu dem kastenförmigen Element (2) ermöglichen.

2. PV-Modul nach Anspruch 1, **dadurch gekennzeichnet, dass** das optische System (5, 6) eine erste reflektierende Einheit (5) mit konkaver Geometrie beinhaltet, die im Innern des kastenförmigen Elements (2) angeordnet ist, wobei diese erste reflektierende Einheit (5) die über die transparente Platte (3) eintretenden Sonnenstrahlen aufnimmt; und eine zweite reflektierende Einheit (6) mit konvexer Geometrie beinhaltet, die mit der Verschlussplatte (3) verbunden ist und dazu dient, die von der ersten reflektierenden Einheit (5) ankommenden Sonnenstrahlen aufzunehmen und in Richtung der photovoltaischen Zelle (4) zu lenken; und dadurch, dass es zweite Mittel (9) beinhaltet, die zumindest ein Zentrieren der ersten reflektierenden Einheit (5) relativ zu dem kastenförmigen Element (2) ermöglichen, und dritte Mittel (10) beinhaltet, die zumindest ein Zentrieren der zweiten reflektierenden Einheit (6), die mit der Verschlussplatte (3) verbunden ist, relativ zu den Seitenwänden (21) des kastenförmigen Elements (2) ermöglichen.

3. PV-Modul nach Anspruch 1 oder 2, **dadurch gekennzeichnet, dass** die ersten Mittel (8) mehrere erste Zapfen (80) beinhalten, die auf der Trägerbasis (7) vorgesehen und dafür ausgelegt sind, mit entsprechenden ersten Durchgangslöchern (81) in Eingriff zu treten, die im Boden (20) des kastenförmigen Elements (2) vorgesehen sind.

4. PV-Modul nach Anspruch 2 oder 3, **dadurch gekennzeichnet, dass** die zweiten Mittel (9) mehrere zweite Zapfen (90) beinhalten, die auf der ersten reflektierenden Einheit (5) vorgesehen und dafür ausgelegt sind, mit entsprechenden zweiten Durchgangslöchern (91) in Eingriff zu treten, die im kastenförmigen Element (2) vorgesehen sind.

5. PV-Modul nach Anspruch 3 oder 4, **dadurch gekennzeichnet, dass** die ersten Zapfen (80) oder die zweiten Zapfen (90) ein kegelförmiges oder kegelstumpfförmiges geometrisches Profil aufweisen, um das Einführen in die entsprechenden ersten oder zweiten Durchgangslöcher (81, 91) zu erleichtern.

6. PV-Modul nach Anspruch 3 oder 5, **dadurch gekennzeichnet, dass** die ersten Zapfen (80) so in die entsprechenden ersten Durchgangslöcher (81) eingeführt werden, dass durch Eingriffspassung die Befestigung der Trägerbasis (7) an dem Boden (20) des kastenförmigen Elements (2) ermöglicht wird.

7. PV-Modul nach Anspruch 4 oder 5, **dadurch gekennzeichnet, dass** die zweiten Zapfen (90) frei in die entsprechenden zweiten Durchgangslöcher (91) eingeführt werden, wobei die zweiten Zapfen (90) nach ihrer Einführung in die zweiten Durchgangslöcher (91) so verformt werden, dass die Befestigung der ersten reflektierenden Einheit (5) an dem kastenförmigen Element (2) ermöglicht wird.

8. PV-Modul nach den Ansprüchen 4, 5 oder 7, **dadurch gekennzeichnet, dass** die zweiten Durchgangslöcher (91) am Boden (20) des kastenförmigen Elements (2) vorgesehen sind.

9. PV-Modul nach einem der Ansprüche von 2 bis 8, **dadurch gekennzeichnet, dass** die dritten Mittel (10) eine längliche Aufnahme (11) beinhalten, die von einer oberen Kante jeder Seitenwand (21) des kastenförmigen Elements (2) hervorragt und zumindest in der Lage ist, die Verschlussplatte (3), mit der die zweite reflektierende Einheit (6) verbunden ist, aufliegend aufzunehmen und seitlich zu umfassen.

10. PV-Modul nach Anspruch 9, **dadurch gekennzeichnet, dass** jede längliche Aufnahme (11) ein L-förmiges Profil aufweist und einen ersten Abschnitt (12) beinhaltet, der geeignet ist, die Verschlussplatte (3) aufliegend aufzunehmen, und einen zweiten Abschnitt (13) beinhaltet, der geeignet ist, seitlich gegen die Verschlussplatte (3) anzuliegen.

11. PV-Modul nach Anspruch 10, **dadurch gekennzeichnet, dass** jede längliche Aufnahme (11) ferner einen dritten Abschnitt (14) beinhaltet, der dem ersten Abschnitt (12) zugewandt und dafür geeignet ist, die Verschlussplatte (3) festzuhalten.

12. PV-Modul nach Anspruch 10 oder 11, **dadurch gekennzeichnet, dass** es die Anwendung von Klebemitteln beinhaltet, die vor dem Anbringen der Verschlussplatte (3) zumindest auf dem ersten Abschnitt (12), vorzugsweise auch auf dem zweiten Abschnitt (13), aufgetragen werden, um die Befestigung der Verschlussplatte (3) an den Seitenwänden (21) des kastenförmigen Elements (2) zu ermöglichen.

## Revendications

1. Un panneau photovoltaïque à haute concentration, comprenant un élément en caisson (2) présentant un fond (20), une paire de parois latérales longitudinales (21) qui s'élèvent à partir du fond (20), et une paire de têtes (22) ; une plaque (3) réalisée dans un matériau transparent pour fermer l'élément en caisson (2), permettant aux rayons solaires de pénétrer à l'intérieur de l'élément en caisson (2) ; une pluralité de modules photovoltaïques (100) logés à l'intérieur de l'élément en caisson (2) pour la production d'énergie électrique à partir de l'énergie solaire ; chaque module photovoltaïque (100) comprenant :
une cellule photovoltaïque (4) pour convertir l'énergie solaire en énergie électrique ;
un système optique (5, 6), positionné à l'intérieur de l'élément en caisson (2), qui reçoit les rayons solaires qui pénètrent à travers la plaque transparente (3) et véhicule lesdits rayons en direction de la cellule photovoltaïque (4);
une base de support (7) sur laquelle sont fixés la cellule photovoltaïque (4) et un circuit électrique relié à la cellule photovoltaïque (4);
le panneau photovoltaïque (1) étant **caractérisé en ce qu'**il comprend : des premiers moyens (8) permettant au moins un centrage de la base de support (7) du module photovoltaïque (100) par rapport au fond (20) de l'élément en caisson (2) ; des moyens (9, 10) pour permettre le centrage du système optique (5, 6) du module photovoltaïque (100) par rapport à l'élément en caisson (2).

2. Le panneau selon la revendication 1, **caractérisé en ce que** le système optique (5, 6) comprend un premier groupe réfléchissant (5) ayant une géométrie concave, positionné à l'intérieur de l'élément en caisson (2), ledit premier groupe réfléchissant (5) reçoit les rayons solaires qui pénètrent à travers la plaque transparente (3) ; et un deuxième groupe réfléchissant (6) ayant une géométrie convexe, associé à la plaque de fermeture (3), qui reçoit les rayons solaires provenant du premier groupe réfléchissant (5) et les véhicule en direction de la cellule photovoltaïque (4) ; et **en ce qu'**il comprend des deuxièmes moyens (9) pour permettre au moins un centrage du premier groupe réfléchissant (5) par rapport à l'élément en caisson (2), et des troisièmes moyens (10) pour permettre au moins un centrage du deuxième groupe réfléchissant (6), associé à la plaque de fermeture (3), par rapport aux parois latérales (21) de l'élément en caisson (2).

3. Le panneau selon la revendication 1 ou 2, **caractérisé en ce que** les premiers moyens (8) comprennent une pluralité de premières goupilles (80) prévues sur la base de support (7), destinées à s'introduire dans des premiers trous débouchants (81) correspondants présents dans le fond (20) de l'élément en caisson (2).

4. Le panneau selon la revendication 2 ou 3, **caractérisé en ce que** les deuxièmes moyens (9) comprennent une pluralité de deuxièmes goupilles (90) présentées par le premier groupe réfléchissant (5), destinées à s'introduire dans des deuxièmes trous débouchants (91) correspondants présents dans l'élément en caisson (2).

5. Le panneau selon la revendication 3 ou 4, **caractérisé en ce que** les premières goupilles (80) ou les deuxièmes goupilles (90) ont un profil géométrique conique ou troncoconique, de manière à faciliter l'introduction dans les premiers ou deuxièmes trous débouchants (81, 91) correspondants.

6. Le panneau selon la revendication 3 ou 5, **caractérisé en ce que** les premières goupilles (80) s'introduisent dans les premiers trous débouchants (81) correspondants par interférence, de manière à permettre la fixation de la base de support (7) au fond (20) de l'élément en caisson (2).

7. Le panneau selon la revendication 4 ou 5, **caractérisé en ce que** les deuxièmes goupilles (90) s'introduisent librement dans les deuxièmes trous débouchants (91) correspondants, les deuxièmes goupilles (90), après leur introduction dans les deuxièmes trous débouchants (91), étant déformées de manière à permettre la fixation du premier groupe réfléchissant (5) à l'élément en caisson (2).

8. Le panneau selon les revendications 4, 5 ou 7, **caractérisé en ce que** les deuxièmes trous débouchants (91) sont prévus au niveau du fond (20) de l'élément en caisson (2).

9. Le panneau selon une des revendications de 2 à 8, **caractérisé en ce que** les troisièmes moyens (10) comprennent un logement longitudinal (11) qui s'étend à partir d'un bord supérieur de chaque paroi latérale (21) de l'élément en caisson (2), destinés au moins à recevoir en appui et à contenir latéralement la plaque de fermeture (3) à laquelle est associé le deuxième groupe réfléchissant (6).

10. Le panneau selon la revendication 9, **caractérisé en ce que** chaque logement longitudinal (11) présente un profil en « L » et comprend une première portion (12), destinée à recevoir en appui la plaque de fermeture (3), et une deuxième portion (13) destinée à servir de butée latérale à la plaque de fermeture (3).

11. Le panneau selon la revendication 10, **caractérisé en ce que** chaque logement longitudinal (11) comprend en outre une troisième portion (14), faisant face à la première portion (12), pouvant retenir la plaque de fermeture (3).

12. Le panneau selon la revendication 10 ou 11, **caractérisé en ce qu'**il comprend l'application de moyens de collage sur au moins la première portion (12), de préférence aussi sur la deuxième portion (13), préliminairement au positionnement de la plaque de fermeture (3), de manière à permettre la fixation de la plaque de fermeture (3) aux parois latérales (21) de l'élément en caisson (2).
